# EUROPÄISCHE PATENTSCHRIFT

(11) **EP 0 433 680 B1**
(45) Veröffentlichungstag und Bekanntmachung des Hinweises auf die Patenterteilung: **08.03.1995**
(21) Anmeldenummer: 90122104.4
(22) Anmeldetag: 19.11.1990
(51) Int. Cl.: G01R 31/305

(54) **Verfahren zur Potentialmessung auf Leiterbahnen einer programmgesteuerten integrierten Schaltung**
Method for measuring the potential of the conductor lines of a program-controlled integrated circuit
Méthode pour la mesure du potentiel des voies conductrices d'un circuit intégré commandé par programme

(30) Priorität: 19.12.1989 DE 3941889
(43) Veröffentlichungstag der Anmeldung: 26.06.1991
(73) Patentinhaber: ICT Integrated Circuit Testing Gesellschaft für Halbleiterprüftechnik mbH, D-85551 Kirchheim (DE); ADVANTEST CORPORATION, Shinjuku-ku, Tokyo 163-08 (JP)
(72) Erfinder: Frosien, Jürgen, Dr.-Ing., W-8012 Riemerling (DE); Tietz, Hans Richard, Dipl.-Phys., W-8035 Gauting (DE)
(74) Vertreter: Tetzner, Volkmar, Dr.-Ing. Dr. jur.

(56) Entgegenhaltungen:
- EP-A- 0 177 717
- EP-A- 0 225 969
- EP-A- 0 392 035
- IBM JOURNAL OF RESEARCH AND DEVELOPMENT. Bd. 34, Nr. 2/3, März 1990, NEW YORKUS Seiten 215 - 226; F.FOX ET AL.: 'A submicron electron-beam tester for VLSIcircuits beyond the 4-Mb DRAM'
- INTERNATIONAL TEST CONFERENCE 1989 PROCEEDINGS August 1989, WASHINGTON USSeiten 917 - 922; Y.TOKUNAGA ET AL.: 'High Performance Electron Beam Testerfor Voltage Measurement on Unpassivated and Passivated Devices'

## Beschreibung

Die Erfindung betrifft ein Verfahren entsprechend dem Oberbegriff des Anspruches 1.

In der Elektronenstrahlmeßtechnik sind Verfahren zur Potentialmessung in integrierten Schaltungen bekannt. Hierbei wird der Elektronenstrahl auf einen festen Punkt der interessierenden Leiterbahn gerichtet und das dabei entstehende Sekundärelektronensignal in einer Meß- und Regelkette ausgewertet.

Mit zunehmender Miniaturisierung der integrierten Schaltungen und der hiermit verbundenen Verringerung der Leiterbahnbreite treten Effekte auf, die eine Potentialmessung behindern. Derartige Effekte werden beispielsweise durch elektrische und magnetische Felder hervorgerufen, die etwa von Bonddrähten oder von starkstromdurchflossenen Leitungen innerhalb der Schaltung herrühren können. Diese Störungen bewirken, daß der Primärelektronenstrahl nicht mehr fest auf der interessierenden Leiterbahn steht, sondern abgelenkt wird und sogar von der Leiterbahn herunterrutschen kann. Dies ist für eine Potentialmessung sehr störend und kann sie u. U. völlig unmöglich machen.

Aus International Test Conference 1989 Proceedings, August 1989, Washington, US; Y. Tokunaga et al.: "High perfomance electron beam tester for voltage measurement on unpassivated and passivated devices", Seiten 917 - 922, ist ein Verfahren gemäß dem Oberbegriff des Anspruches 1 bekannt. Bei diesem Verfahren kommt eine in der Spannung einstellbare Absaugelektrode zur Anwendung, mit deren Hilfe sowohl an passivierten als auch an nichtpassivierten Schaltungen gute Meßergebnisse erzielt werden können.

Der Erfindung liegt die Aufgabe zugrunde, das im Oberbegriff des Anspruches 1 vorausgesetzte Verfahren dahin weiterzuentwickeln, daß elektrische und/oder magnetische Störungen bei der Potentialmessung auf Leiterbahnen integrierter Schaltungen kompensiert werden.

Die Aufgabe wird erfindungsgemäß durch das kennzeichnende Merkmal des Anspruches 1 gelöst.

Weitere Merkmale der Erfindung werden im Zusammenhang mit der folgenden Beschreibung und der Zeichnung näher erläutert.

In der Zeichnung zeigen
- Fig.1: eine Darstellung eines durch eine zeilenweise Abtastung einer integrierten Schaltung erzeugten Logikbildes,
- Fig.2: eine Darstellung eines Logikbildes nach Abtastung einer einzigen Zeile längs der Linie II-II,
- Fig.3: eine Darstellung eines Logikbildes nach Abtastung einer einzigen, durch elektrische und/oder magnetische Felder gestörten Abtastzeile einer integrierten Schaltung.

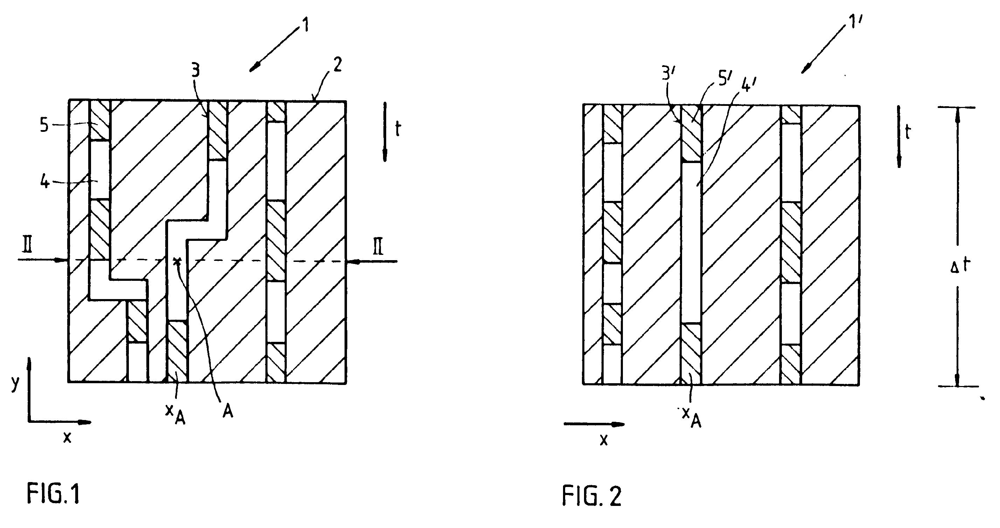

In Fig.1 ist ein zweidimensionales Logikbild 1 einer integrierten Schaltung 2 dargestellt. Dazu wird ein gepulster Elektronenstrahl auf die integrierte Schaltung 2 fokussiert. Zur Potentialmessung auf Leiterbahnen 3 wird die integrierte Schaltung 2 mit einem Programm betrieben, wobei während einer periodischen Abarbeitung einer Programmschleife die zu bestimmten Zeitpunkten auftretenden logischen Zustände 4, 5 in dem zweidimensionalen Logikbild 1 mittels des Elektronenstrahls dargestellt werden. Hierbei wird der Elektronenstrahl mit der Wiederholfrequenz der Programmschleife gepulst und dessen Phase kontinuierlich verschoben. Dadurch entsteht das zweidimensionale Logikbild 1 (x/y-Achse), dem eine zusätzliche Zeitachse (t-Achse) überlagert ist. Auf diese Weise ergibt sich eine genaue Wiedergabe der Oberflächenstruktur der integrierten Schaltung 2.

Es sei nun angenommen, daß auf einer Leiterbahn 3 ein bestimmter Punkt A einer genaueren Messung unterzogen werden soll.

Zunächst wird in einer Hilfsmessung, die während eines bestimmten Zeitbereichs Δt des Programms erfolgt, die integrierte Schaltung 2 durch den Elektronenstrahl nur längs der den Punkt A enthaltenden Linie II-II oder längs einer anderen, senkrecht zur Zeitachse verlaufenden Linie abgetastet.

Auf einem Anzeigegerät entsteht dann ein Logikbild 1′ gemäß Fig. 2. Hierbei handelt es sich wiederum um eine zweidimensionale Darstellung, bei der einerseits der Ort x und andererseits die Zeit t aufgetragen sind. Der Punkt A mit der Koordinate x_{A} der Fig. 1 ist in der Fig. 2 bei der x-Koordinate x_{A} der Leiterbahn 3′ über den gesamten gemessenen Zeitbereich Δt dargestellt. Außerdem sind auf den einzelnen Leiterbahnen die logischen Zustände 4′, 5′ veranschaulicht, die durch ihren Hell-Dunkelkontrast den Potentialverlauf zeigen. Eine derartige Darstellung mit gerade verlaufenden Leiterbahnen 3′, wie sie in Fig. 2 dargestellt sind, ergibt sich jedoch nur im Idealfall, d.h. ohne elektrische und/oder magnetische Störungen.

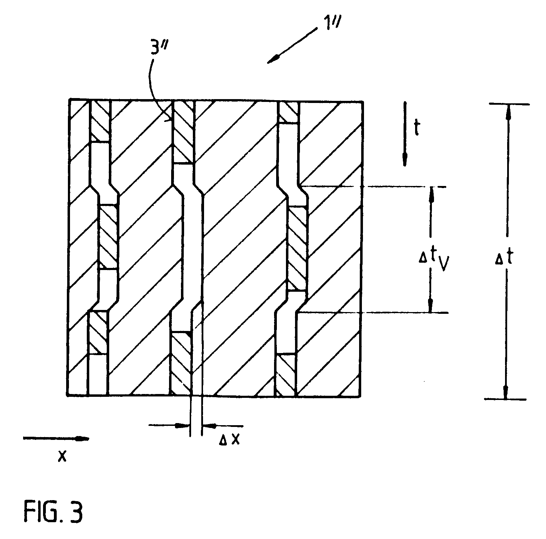

Mit zunehmender Miniaturisierung der integrierten Schaltung 2 und einer abnehmenden Leiterbahnbreite treten Effekte auf, die die Potentialmessung behindern. Dazu zählen elektrische und/oder magnetische Felder, die von Bonddrähten oder starkstromdurchflossenen Leitungen in der Nähe der Messung herrühren und den Elektronenstrahl ablenken. Infolgedessen werden sich Logikbilder 1˝ gemäß Fig. 3 ergeben, bei denen sich die ansonsten geradlinigen Leiterbahnen 3˝ in einem Zeitbereich Δt_{V} einen seitlichen (räumlichen) Versatz Δx aufweisen.

Bei einer quantitativen Signalmessung tastet der Elektronenstrahl nicht die gesamte, den Punkt A enthaltende Linie II-II ab, sondern er wird statisch auf den Punkt A gerichtet. Dies wiederum kann jedoch dazu führen, daß der Elektronenstrahl bei entsprechend großen elektrischen und/oder magnetischen Störungen und einem entsprechend großen Versatz Δx derart abgelenkt wird, daß er von der Leiterbahn 3 herunterrutscht und somit eine Messung völlig unmöglich macht.

Bei dem erfindungsgemäßen Verfahren wird diese Beeinträchtigung dadurch vermieden, daß zunächst die oben beschriebene Hilfsmessung durch Abtastung einer einzigen, den interessierenden Punkt A enthaltenden Abtastlinie II-II oder einer anderen, senkrecht zur Zeitachse verlaufenden Linie durchgeführt wird. Der im Logikbild 1˝ auftretende, durch elektrische und/oder magnetische Störungen verursachte räumliche Versatz Δx der Leiterbahn 3˝ wird in seiner zeitlichen Abhängigkeit durch eine (nicht veranschaulichte) Einrichtung erfaßt, ausgewertet und gespeichert.

In der Hauptmessung, die während desselben Zeitbereichs Δt des Programms wie die Hilfsmessung erfolgt, wird der Elektronenstrahl statisch auf den Punkt A der Leiterbahn 3 gerichtet (Fig. 1). Von der oben erwähnten Speichereinrichtung wird der bei der Hilfmessung ermittelte, gespeicherte Versatz (in seiner räumlich-zeitlichen Abhängigkeit) als Kompensationsgröße der Ablenkeinrichtung des Elektronenstrahls zugeführt, so daß im Zeitbereich Δt_{V} der auftretenden elektrischen und/oder magnetischen Störungen eine entsprechende Korrektur der Ausrichtung des Elektronenstrahls erfolgt. Zur Ermittlung der Kompensationsgrößen wird eine Auswertung aufeinanderfolgender Bildzeilen im Logikbild 1˝ nach der Korrelationsmethode durchgeführt. Dabei kommen 1-, 2- oder 3-dimensionale Kreuz- und Autokorrelationsrechnungen im reellen Raum oder Fourrierraum zwischen einzelnen oder mehreren aufeinanderfolgenden Datenbereichen zur Anwendung.

Auf diese Weise können quantitativ hochwertige Potentialmessungen an einzelnen, besonders interessierenden Punkten einer integrierten Schaltung durchgeführt werden, ohne daß sie durch elektrische und/oder magnetische Störungen beeinflußt werden.

Die Ablenkeinrichtungen für den Elektronenstrahl, denen die Kompensationsgrößen in Form von Korrekturströmen oder -spannungen zugeführt werden, können in üblicher Weise durch Ablenkspulen oder Ablenkkondensatoren gebildet werden.

Die Hilfsmessung des erfindungsgemäßen Verfahrens muß nicht unbedingt auf derselben Leiterbahn erfolgen, auf der die Hauptmessung durchgeführt wird. Es genügt die Vornahme der Hilfsmessung an einer Leiterbahn, an der bezüglich des Versatzes gleiche Verhältnisse vorliegen wie an der bei der Hauptmessung zu untersuchenden Leiterbahn.

## Patentansprüche

1. Verfahren zur Potentialmessung auf Leiterbahnen (3) einer programmgesteuerten integrierten Schaltung (2), wobei während einer periodischen Abarbeitung einer Programmschleife die zu bestimmten Zeitpunkten auftretenden logischen Zustände (4, 5; 4′, 5′) in einem zweidimensionalen Logikbild mittels eines Elektronenstrahles dargestellt werden, der mit der Wiederholfrequenz der Programmschleife gepulst ist und dessen Phase kontinuierlich verschoben wird,
gekennzeichnet durch folgende Verfahrensschritte:
a) zunächst wird in einer Hilfsmessung, die während eines bestimmten Zeitbereiches (Δt) des Programmes erfolgt, die integrierte Schaltung (2) durch den Elektronenstrahl in einer wenigstens eine Leiterbahn (3) kreuzenden einzigen Abtastzeile abgetastet und hierbei ein im Logikbild (1˝) auftretender, durch elektrische und/oder magnetische Störungen verursachter räumlicher Versatz (Δx) der Leiterbahn (3˝) in seiner zeitlichen Abhängigkeit bestimmt und gespeichert;
b) sodann wird in einer Hauptmessung, die während desselben Zeitbereiches (Δt) des Programmes wie die Hilfsmessung erfolgt, der Elektronenstrahl statisch auf die genannte Leiterbahn (3) gerichtet und hierbei die durch die Hilfsmessung ermittelte zeitliche Abhängigkeit des räumlichen Versatzes (Δx) als Kompensationsgröße zur Korrektur von durch elektrische und/oder magnetische Störungen verursachten Ablenkungen des Elektronenstrahles verwendet,
c) wobei die Ermittelung und größenmäßige Bestimmung des räumlichen Versatzes (Δx) durch eine Auswertung aufeinanderfolgender Zeilen des Logikbildes (1˝) nach einer Korrelationsmethode erfolgt.

## Claims

1. Method of potential measurement on conductive tracks of a program-controlled integrated circuit (2), in which during periodic finishing of a program loop the logic states (4, 5; 4′, 5′ ) occurring at specific points in time are represented in a two-dimensional logic image by means of an electron beam which is pulsed with the repetition frequency of the program loop and the phase of which is continuously shifted, characterised by the following method steps:
a) first of all in an auxiliary measurement, which takes place during a specific time range (Δt) of the program, the integrated circuit (2) is scanned by the electron beam in one single scan line crossing at least one conductive track (3) and during this a spatial displacement (Δx) of the conductive track (3˝) which occurs in the logic image (1˝) and is caused by electrical and/or magnetic disturbances is determined in its time dependence and stored;
b) then in a principal measurement, which takes place during the same time range (Δt) of the program as the auxiliary measurement, the electron beam is directed statically onto the conductive track (3) to be measured, and during this the time dependence of the spatial displacement (Δx) determined by the auxiliary measurement is used as compensation value for correction of deflections of the electron beam caused by electrical and/or magnetic disturbances,
c) the determination and quantitative analysis of the spatial displacement (Δx) being achieved by evaluation of successive lines of the logic image (1˝) according to a correlation method.

## Revendications

1. Procédé de mesure de potentiel sur des pistes (3) d'un circuit intégré (2) commandé par programme, suivant lequel les états logiques (4, 5′, 4′, 5′) apparaissant en des instants déterminés au cours d'un accomplissement périodique d'une boucle de programme sont représentés dans une image logique bi-dimensionnelle au moyen d'un faisceau électronique qui est pulsé à la fréquence de récurrence de la boucle de programme et dont la phase est décalée en continu,
caractérisé par les étapes suivantes du procédé :
a) tout d'abord le circuit intégré (2) est exploré au cours d'une mesure auxiliaire, qui a lieu pendant un intervalle de temps déterminé (Δt) du programme, par le faisceau électronique sur une ligne unique d'exploration croisant au moins une piste (3) et ainsi un décalage dans l'espace (Δx) de la piste (3˝), qui apparait dans l'image logique (1˝) et qui est produit par des parasites électriques et/ou magnétiques, est déterminé dans sa relation par rapport au temps et mémorisé ;
b) ensuite le faisceau électronique est dirigé statiquement sur ladite piste (3) au cours d'une mesure principale, qui a lieu pendant le même intervalle de temps (Δt) du programme que la mesure auxiliaire, et de plus la relation en fonction du temps du décalage dans l'espace (Δx) qui a été déterminée par la mesure auxiliaire est utilisée en grandeur de compensation pour la correction des déviations du faisceau électronique provoquées par des parasites électriques et/ou magnétiques ;
c) la détection et la détermination de la grandeur du décalage dans l'espace (Δx) étant effectuées par une analyse des lignes successives de l'image logique (1˝) par une méthode de corrélation.
